(19) Europäisches Patentamt
European Patent Office
Office européen des brevets

(11)  **EP 2 726 833 B1**

(12)  **EUROPÄISCHE PATENTSCHRIFT**

(45) Veröffentlichungstag und Bekanntmachung des Hinweises auf die Patenterteilung:
**04.11.2015 Patentblatt 2015/45**

(21) Anmeldenummer: **12725395.3**

(22) Anmeldetag: **01.06.2012**

(51) Int Cl.:
***G01L 9/00*** *(2006.01)*    ***G01L 27/00*** *(2006.01)*

(86) Internationale Anmeldenummer:
**PCT/EP2012/060335**

(87) Internationale Veröffentlichungsnummer:
**WO 2013/004438 (10.01.2013 Gazette 2013/02)**

(54) **VERFAHREN ZUM BETREIBEN EINES ABSOLUT- ODER RELATIVDRUCKSENSORS MIT EINEM KAPAZITIVEN WANDLER**

METHOD OF OPERATING AN ABSOLUTE OR RELATIVE PRESSURE SENSOR USING A CAPACITIVE TRANSDUCER

PROCÉDÉ POUR FAIRE FONCTIONNER UN CAPTEUR DE PRESSION ABSOLUE OU RELATIF AVEC UN TRANSDUCTEUR CAPACITIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.07.2011 DE 102011078557**

(43) Veröffentlichungstag der Anmeldung:
**07.05.2014 Patentblatt 2014/19**

(73) Patentinhaber: **Endress+Hauser GmbH+Co. KG**
**79689 Maulburg (DE)**

(72) Erfinder:
• **UEHLIN, Thomas**
  **79650 Schopfheim (DE)**
• **WOSNITZA, Elmar**
  **79104 Freiburg (DE)**
• **GETMAN, Igor**
  **79539 Lörrach (DE)**

(74) Vertreter: **Andres, Angelika Maria**
**Endress+Hauser (Deutschland) AG+Co. KG**
**PatServe**
**Colmarer Strasse 6**
**79576 Weil am Rhein (DE)**

(56) Entgegenhaltungen:
**US-A- 6 029 524    US-A1- 2009 301 211**

EP 2 726 833 B1

**Beschreibung**

Die vorliegende Erfindung betrifft ein Verfahren zum Betreiben eines Absolut- oder Relativdrucksensors mit einem kapazitiven Wandler.

Ein solcher Drucksensor weist eine Messmembran, mindestens einen Gegenkörper und einen kapazitiven Wandler mit mindestens einer ersten druckabhängigen Kapazität und einer zweiten druckabhängigen Kapazität auf,

wobei die Messmembran ein Volumen druckdicht in eine erstes Teilvolumen und zweites Teilvolumen teilt, wobei das zweite Teilvolumen in einer Messkammer zwischen der Messmembran und dem Gegenkörper eingeschlossen ist,

wobei eine Auslenkung der Messmembran von einer Druckmessgröße p abhängt, welche eine Differenz zwischen einem ersten Druck $p_1$ in dem ersten Teilvolumen und einem zweiten Druck $p_2$ in dem zweiten Teilvolumen in der Messkammer ist,

wobei die erste Kapazität und die zweite Kapazität jeweils zwischen einer Elektrode an der Messmembran und einer Gegenelektrode mit einer im wesentlichen druckunabhängigen Position gemessen werden,

wobei ein jeweils aktueller Wert der Druckmessgröße p in Abhängigkeit von der ersten Kapazität und von der zweiten Kapazität ermittelt wird.

Der genaue Zusammenhang zwischen der Druckmessgröße p und den beiden Kapazitäten hängt insbesondere von der Position der Elektroden im Verhältnis zur Messmembran und der Biegecharakteristik der Messmembran ab. Sofern diese Randbedingungen bauartbedingt festgelegt sind, kann die Druckmessgröße p in Abhängigkeit der aktuellen Messwerte der Kapazitäten und ggf. weiterer Störgrößen wie der Temperatur bestimmt werden. Dies setzt jedoch voraus, dass die genannten, bauartbedingten Charakteristika des Drucksensors, welche die Übertragungsfunktionen beeinflussen, hinreichend stabil sind, und dass sich der Drucksensor insbesondere zumindest so weit im thermischen Gleichgewicht befindet, dass die Charakteristika nicht zu sehr von den Gleichgewichtsbedingungen abweichen.

US 6029524 offenbart einen Drucksensor mit zwei druckabhängigen Messkondensatoren, deren Messwerte verglichen werden, um Kalibrierbedarf festzustellen, zusätzlich ist ein druckabhängiger Kondensator vorgesehen. Ein Schaltnetzwerk kann die Kondensatoren mit einer Betriebsschaltung verbinden.

US2009301211 (A1) offenbart einen kapazitiven Drucksensor mit zwei Kondensatoren, die eine unterschiedliche messgrößenabhängige Übertragungsfunktion aufweisen. Ein Fehler wird signalisiert, wenn mindestens einer der Kondensatoren einen Kapazitätswert aufweist, der Außerhalb eines für ihn spezifizierten Wertebereichs liegt.

In der Veröffentlichung EP 2 189 774 A1 wird ein Verfahren zur Kompensation schneller Temperaturänderungen offenbart, welches darauf beruht, dass für gemessene Werte der Messkapazität $C_p$ (dort $C_m$ genannt) die gemessenen Werte der Referenzkapazität $C_r$ mit Erwartungswerten der Referenzkapazität $C_r$, die aus den gemessenen Werten der Messkapazität $C_p$ folgen verglichen werden, und wobei ein Temperatursprung festgestellt wird, wenn der Messwert der Referenzkapazität außerhalb eines Toleranzbereichs um einen Erwartungswert liegt, und wobei dann für den Druckmesswert eine Korrekturfunktion ermittelt wird, die spezifisch den Einfluss des Temperatursprungs auf den Druckmesswert korrigieren soll. In der genannten Veröffentlichung wird also gelehrt, Veränderungen der Übertragungsfunktionen als Folge eines Temperatursprungs zu deuten und dementsprechend bei der Auswertung der Kapazitäten modellbasiert zu kompensieren. Wenngleich dieser Ansatz seine Berechtigung hat, verkennt er, dass eine Veränderung der Übertragungsfunktion auch andere Ursachen haben kann, beispielsweise eine permanente Veränderung, insbesondere Schädigung der Messzelle. Damit besteht die Gefahr, dass eine solche Veränderung der Messzelle unerkannt bleibt, und zwar mit der Folge, dass eine funktionierende Druckmessung fingiert wird, obwohl die ausgegebenen Messwerte ggf. nichts mehr mit dem aktuellen Druck zu tun haben.

Es ist daher die Aufgabe der vorliegenden Erfindung, hier Abhilfe zu schaffen.

Die Aufgabe wird erfindungsgemäß gelöst durch das Verfahren gemäß dem unabhängigen Patentanspruch 1.

Das erfindungsgemäße Verfahren zum Betreiben eines Drucksensors, wobei der Drucksensor eine Messmembran mindestens einen Gegenkörper und einen kapazitiven Wandler mit mindestens einer ersten druckabhängigen Kapazität und einer zweiten druckabhängigen Kapazität aufweist,

wobei die Messmembran ein Volumen druckdicht in eine erstes Teilvolumen und zweites Teilvolumen teilt, wobei das zweite Teilvolumen in einer Messkammer zwischen der Messmembran und dem Gegenkörper eingeschlossen ist,

wobei eine Auslenkung der Messmembran von einer Druckmessgröße p abhängt, welche eine Differenz zwischen einem ersten Druck $p_1$ in dem ersten Teilvolumen und einem zweiten Druck $p_2$ in dem zweiten Teilvolumen in der Messkammer ist,

wobei die erste Kapazität und die zweite Kapazität jeweils zwischen einer Elektrode an der Messmembran und einer Gegenelektrode mit einer im wesentlichen druckunabhängigen Position gemessen werden,

wobei ein jeweils aktueller Wert der Druckmessgröße p in Abhängigkeit von der ersten Kapazität und von der zweiten Kapazität ermittelt wird, und wobei für einen intakten Drucksensor im thermischen Gleichgewicht die zweite Kapazität als eine vorgegebene Funktion der ersten Kapazität und ggf. der Temperatur darstellbar ist, ist ein Verfahren welches die folgenden Schritte aufweist:

Überwachen, ob erfasste Wertepaare der ersten Kapazität und der zweiten Kapazität innerhalb eines vorgegeben Toleranzbereichs tatsächlich dem Zusammenhang der vorgegebenen Funktion entsprechen, und

Feststellen einer Veränderung und/oder Beschädigung des Sensors, wenn dies für einen Zeitraum, der länger andauert als ein Zeitgrenzwert, nicht der Fall ist,

wobei der Zeitgrenzwert eine Funktion der Abweichung der Werte der ersten Kapazität und der zweiten Kapazität von dem Zusammenhang der Funktion ist.

In einer Weiterbildung der Erfindung ist der Zeitgrenzwert ein vorgegebener Grenzwert, insbesondere eine Zeitkonstante, welche das Erreichen eines Gleichgewichtszustands des Drucksensors nach einem Temperatursprung beschreibt, oder ein Vielfaches dieser Zeitkonstanten.

Das Vielfache kann eine beliebige rationale Zahl größer eins sein, insbesondere ein ganzzahliges Vielfaches.

In einer Weiterbildung der Erfindung weist ein intakter Drucksensor einen ersten intakten Betriebszustand und einen zweiten intakten Betriebszustand auf, wobei für einen intakten Drucksensor im ersten Betriebszustand im thermischen Gleichgewicht die zweiten Kapazität als eine erste vorgegebene Funktion der ersten Kapazität und ggf. der Temperatur darstellbar ist, wobei für einen intakten Drucksensor im zweiten Betriebszustand im thermischen Gleichgewicht die zweiten Kapazität als eine zweite vorgegebene Funktion der ersten Kapazität und ggf. der Temperatur darstellbar ist, wobei das Verfahren umfasst:

Erfassen von Wertepaaren der ersten Kapazität und der zweiten Kapazität Prüfen, ob die erfassten Wertepaare der ersten Kapazität und der zweiten Kapazität innerhalb eines vorgegeben Toleranzbereichs tatsächlich dem Zusammenhang einer der vorgegebenen Funktionen entsprechen, und

Feststellen einer Veränderung und/oder Beschädigung des Sensors, wenn dies für einen Zeitraum, der länger andauert als ein Zeitgrenzwert, nicht der Fall ist.

In einer Weiterbildung der Erfindung geht der Drucksensor irreversibel von dem ersten intakten Betriebszustand in den zweiten Betriebszustand über.

Die vorgegebene Funktion kann dem entsprechend insbesondere auch eine ausgewählte Funktion von mehreren Funktionen sein die jeweils einem von mehreren definierten Betriebszuständen entsprechen.

In diesem Fall wird zunächst überprüft, ob sich der Sensor im ersten Betriebszustand befindet. Falls dies nicht der Fall ist, kann überprüft werden, ob sich der Sensor im zweiten Betriebszustand befindet, es folgt dann das Feststellen einer Beschädigung des Sensors, falls dies für einen Zeitraum, der länger andauert als ein Zeitgrenzwert, nicht der Fall ist. Wenn allerdings einmal festgestellt wird dass sich der Sensor im zweiten Betriebszustand befindet, dann kann darauf verzichtet werden, zu überprüfen, ob sich der Sensor im ersten Zustand befindet.

In einer Weiterbildung der Erfindung umfasst der kapazitive Wandler einen Differentialkondensator, mit mindestens einen ersten Kondensator, dessen erste Kapazität eine erste Übertragungsfunktion aufweist, und einen zweiten Kondensator, dessen zweite Kapazität eine zweite Übertragungsfunktion aufweist, wobei die Übertragungsfunktionen sich vorzugsweise in ihren Druckabhängigkeiten unterscheiden. Hierbei wird insbesondere angestrebt, dass die beiden Kapazitäten gleich sind, wenn die Druckmessgröße den Wert Null aufweist; in diesem Fall wird häufig die Differenz der Kapazitäten $C_1 - C_2$ normiert mit der Kapazität $C_2$ zur Bestimmung der Druckmessgröße herangezogen, also $p = p((C_1 - C_2) / C_2)$.

In einer Weiterbildung der Erfindung umfasst der Differentialkondensator eine kreisflächenförmige Messelektrode und eine kapazitätsgleiche kreisringförmige Referenzelektrode, welche die Messelektrode umgibt, wobei die Messelektrode und die Referenzelektrode insbesondere an einer der Messmembran zugewandten Oberfläche eines Gegenkörpers angeordnet sind, wobei die Messmembran eine kreisscheibenförmige Membranelektrode aufweist, die sich vorzugsweise mindestens bis zum Außenrand der kreisringförmigen Referenzelektrode erstreckt. Entsprechend gilt für die Druckmessgröße p:

$$p = p((C_p - C_r) / C_r) \qquad (I),$$

wobei $C_p$ und $C_r$ die Kapazitäten zwischen der Messelektrode und der Membranelektrode bzw. der Referenzelektrode und der Membranelektrode bezeichnen.

In einer Weiterbildung der Erfindung umfasst der Sensor eine keramische, kreisscheibenförmige Messmembran und einen keramischen kreisplattenförmigen Gegenkörper, wobei die Messmembran entlang einer umlaufenden Fügestelle unter der Bildung der Messkammer druckdicht mit dem Gegenkörper verbunden ist.

In einer Weiterbildung der Erfindung ist der Drucksensor in einem metallischen Gehäuse angeordnet, wobei der Drucksensor mit der Messmembran eine Gehäuseöffnung verschließt, durch welche die Messmembran mit einem Mediendruck beaufschlagbar ist, wobei das Gehäuse eine ringförmige Dichtfläche aufweist, welche die Gehäuseöffnung umgibt, wobei zwischen der Messmembran und der Dichtfläche ein Dichtring eingespannt ist, und wobei der Drucksensor auf der der Messmembran abgewandten Rückseite des Gegenkörpers mit einer Einspannvorrichtung abgestützt ist, um dem Drucksensor gegen den Dichtring gespannt zu halten. Derartige Dichtringe weisen oft Elastomere auf, wobei die Dichtringe ihre elastischen Eigenschaften irreversibel verändern können, wenn sie einer hohen Temperatur ausgesetzt werden. Dies kann aufgrund der resultierenden Abnahme der Einspannkraft zu Problemen hinsichtlich der Messgenauigkeit führen, wie im Europäischen Patent Nr. EP 1 518 097 beschrieben ist. Eine geringere Einspannkraft kann nämlich gleichermaßen zu einer Verringerung von Biegemomenten führen, welche die Messmembran radial stauchen oder strecken, wenn nicht die Einspannvorrichtung in der Weise konzipiert und dimensioniert ist, wie das genannte Europäische Patent offenbart. Das Stauchen oder Strecken der Messmembran beeinflusst jedoch die effektive Steifigkeit der Messmembran, wobei eine Veränderung dieser Einflüsse im Messbetrieb einen systematischen Messfehler bewirkt.

Das Stauchen bzw. Strecken der Messmembran kann insbesondere eine andere Form Biegelinie der Messmembran bewirken, also der Auslenkung der Messmembran $z(r,p) / z(0,p)$ aus der Ruhelage bei einem gegebenen Druck p. Diese veränderte Form der Biegelinie kann erkannt werden, da sich der funktionale Zusammenhang zwischen den Kapazitäten mit der Biegelinie ändert, insbesondere dann, wenn die radiale Position der die Kapazitäten definierenden Elektroden hinreichend unterscheidbar sind, wie dies beispielsweise der Fall ist bei der zuvor beschriebenen Anordnung eines Differentialkondensators mit einer zentralen, kreisscheibenförmigen Elektrode und einer umgebenden, kapazitätsgleichen Ringelektrode.

Nun können für verschiedene Alterungszustände und einen Typ von Dichtring bzw. für verschiedene Einspannzustände eines Drucksensortyps mit einem solchen Dichtring der Zusammenhang zwischen dem Druck und den Kapazitäten $p(c_p, c_r, T)$ und $c_r(c_p, T)$ bzw. $c_p(c_r, T)$ beispielsweise experimentell und/oder durch Simulation ermittelt werden.

Zur Implementierung des erfindungsgemäßen Verfahrens ist der Drucksensor an eine Betriebs- und Verarbeitungsschaltung angeschlossen, welche insbesondere einen Mikroprozessor umfassen kann, der anhand der $c_r(c_p)$ bzw. $c_p(c_r)$ oder $c_r(c_p, T)$ bzw. $c_p(c_r, T)$ den Zustand des Drucksensors ermittelt.

Die Erfindung wird nun anhand der in den Zeichnungen dargestellten Ausführungsbeispiele erläutert. Es zeigt:

Fig. 1: einen Längsschnitt durch einen kapazitiven Drucksensor;

Fig. 2: ideale Biegelinien für eine am Rand eingespannte Messmembran (+) und für eine freie Messmembran ($\Delta$);

Fig. 3: den Verlauf der Übertragungsfunktion $(C_p - C_r) / C_r$ in Abhängigkeit von der Auslenkung der Messmembran für einen Differentialkondensator mit einer am Rand eingespannten Messmembran (+) und mit einer freien Messmembran ($\Delta$); und

Fig. 4: die Funktion $c_r(c_p)$ für die Biegelinie einer am Rand eingespannten Messmembran bei Referenztemperatur (+) und bei einer um 100 K erhöhten Temperatur ($\bigcirc$), sowie für eine freie Messmembran bei Raumtemperatur ($\Delta$).

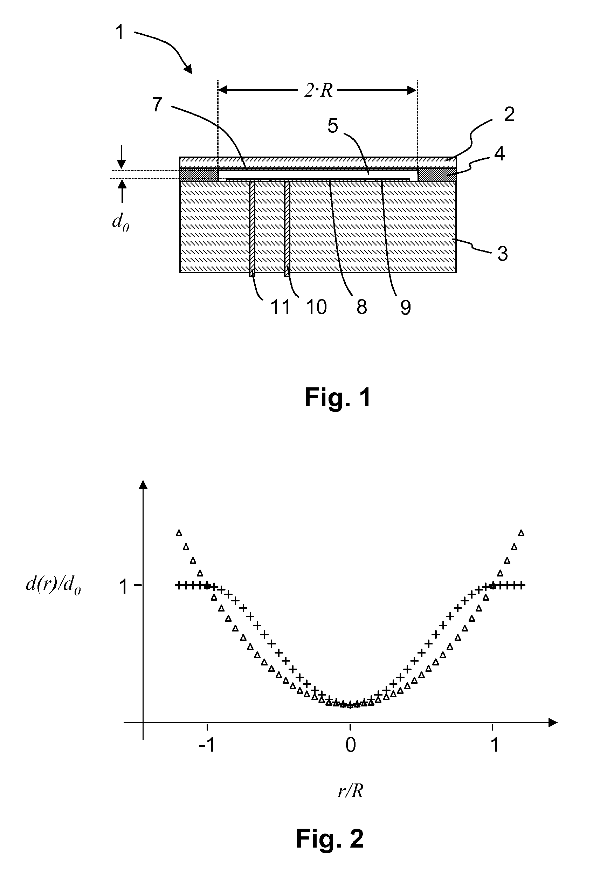

Der in Fig. 1 dargestellte Drucksensor 1 umfasst eine kreisscheibenförmige, keramische Messmembran 2, die mit einem erheblich steiferen kreisplattenförmigen, keramischen Gegenkörper 3 entlang einer umlaufenden Fügestelle 4 unter Bildung einer Messkammer 5 zwischen dem Gegenkörper 3 und der Messmembran 2 druckdicht gefügt ist. Die Messmembran und der Gegenkörper können insbesondere Korund aufweisen. Die Fügestelle kann insbesondere ein Aktivhartlot, beispielsweise ein Zr-Ni-Ti-Aktivhartlot oder Glas aufweisen.

Die Messmembran weist auf ihrer gegenkörperseitigen Oberfläche eine vollflächige Membranelektrode 7 auf, die beispielsweise eine Metallschicht, insbesondere eine Ta-Schicht umfasst, wobei die Elektrode einen Durchmesser von 2 R aufweist, wobei R der Radius des auslenkbaren Bereichs der Messmembran ist, der dem Innenradius der Fügestelle entspricht. Auf der messmembranseitigen Oberfläche des Gegenkörpers ist eine zentrale, kreisflächenförmige Messelektrode 8 angeordnet, die von einer bezüglich der Membranelektrode 7 in der Ruhelage der Messmembran 2 im wesentlichen kapazitätsgleichen kreisringförmigen Referenzelektrode 9 kontaktiert ist. Der Abstand der Referenzelektrode 9 zur Messelektrode 8 und zur Fügestelle 4 beträgt jeweils etwa 0,1 R. Die Referenzelektrode 9 und die Messelektrode 8 sind über metallische Durchführungen 10, 11 durch den Grundkörper elektrisch kontaktiert. Die Membranelektrode 7 kann beispielsweise über die Fügestelle auf Schaltungsmasse gelegt sein.

Die in Fig. 2 dargestellten Kurven zeigen den Abstand zwischen der Messmembran und einer ebenen Oberfläche eines Gegenkörpers in Abhängigkeit vom Radius, bei einer Auslenkung der Messmembran in deren Zentrum um einen halben Ruheabstand $d_0$, und zwar für eine am Rand eingespannte Messmembran (+) und für eine freie Messmembran ($\Delta$). Die Kurven beschreiben den Verlauf schematisch, und entsprechen nicht genau dem tatsächlichen Verlauf, der beispielsweise mit FEM-Simulationen in Kombination mit experimentellen Arbeiten zu erhalten wäre. Tatsächlich kommt es auf die Kenntnis des genauen Kurvenverlaufs hier nicht an, vielmehr sollen die Kurven nur darstellen, dass in Abhängigkeit von Randbedingungen wie der Einspannsituation die Form der Durchbiegung der Membran sich erheblich verändern kann. Der Übergang von der Form der am Rand eingespannten Messmembran zur Form der freien Messmembran kann beispielsweise durch ein Versagen der Verbindung zwischen der Messmembran und der Fügestelle verursacht werden.

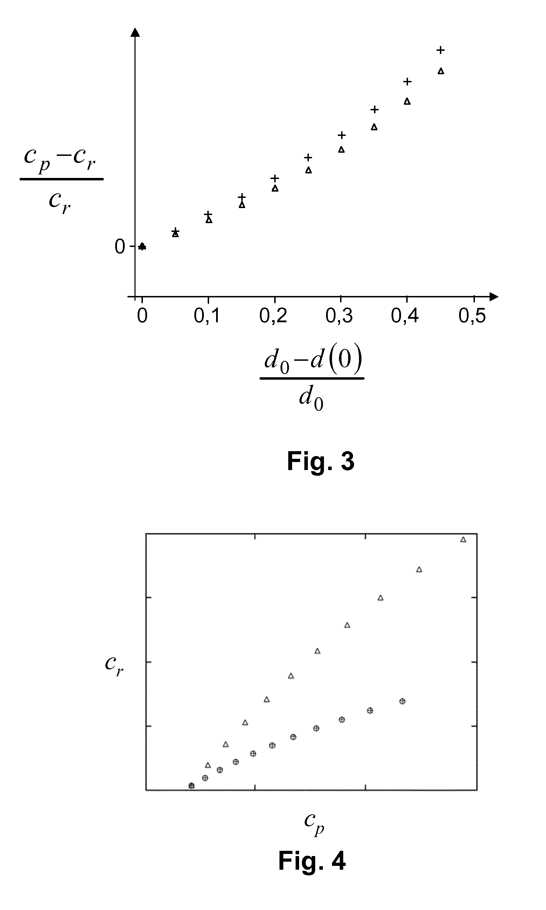

Die aus den unterschiedlichen Biegelinien folgenden Übertragungsfunktionen $(C_p - C_r) / C_r$ in Abhängigkeit von der Auslenkung der Messmembran sind für den Differentialkondensator des Drucksensors aus Fig. 1 mit einer intakten Verbindung zwischen der Messmembran und der Fügestelle (+) und nach dem Versagen dieser Verbindung (Δ) in Fig. 3 dargestellt. Wenngleich die Übertragungsfunktionen deutliche Abweichungen voneinander zeigen und somit zu Messfehlern führen, ist doch der Fehler alleine anhand des Verlaufs der Übertragungsfunktion nicht erkennbar.

Eine Betrachtung der in Fig. 4 dargestellten Funktion $c_r(c_p)$ ermöglicht jedoch, eine eindeutige Unterscheidung zwischen den einzelnen Zuständen des Sensors. Die Funktionen $c_r(c_p)$ einer am Rand eingespannten Messmembran bei Referenztemperatur (+) und bei einer gegenüber der Referenztemperatur um 100 K erhöhten Temperatur (○) für eine Auslenkung der Messmembran um bis zu dem halben Gleichgewichtsabstand unterscheiden sich praktisch kaum. Für eine intakte Messzelle ist insoweit bei konstanten Bedingungen allenfalls eine Variation der Funktionen $c_r(c_p)$ innerhalb eines relativ engen Toleranzbereichs zu erwarten. Die hier dargestellten Kurven sind unter Annahme der Gültigkeit einer Biegelinienform $[1-(r/R)^2]^2$ ermittelt. Für einen konkreten Drucksensor ist der tatsächliche Verlauf der $c_r(c_p)$ bzw. $c_p(c_r)$ über den Temperatureinsatzbereich des Drucksensors experimentell zu bestimmen, um einerseits die Funktion und andererseits einen sinnvollen Toleranzbereich definieren zu können. Die Funktion $c_r(c_p)$ für die freie Messmembran (Δ), welche dem Zustand nach dem Versagen der Verbindung zwischen der Fügestelle und der Messmembran entspricht und hier bei Referenztemperatur dargestellt ist, zeigt dagegen einen deutlich anderen Verlauf, der außerhalb jeglichen sinnvollen Toleranzbands um die Funktion für den intakten Sensor liegen sollte.

Hier setzt das erfindungsgemäße Verfahren an, wonach überprüft wird, ob sich gemessene Werte für $c_r(c_p)$ der erwarteten Funktion eines intakten Drucksensors entsprechen. Falls dies im thermischen Gleichgewicht des Drucksensors nicht der Fall ist, wird eine Veränderung des Drucksensors festgestellt. Dies kann der Übergang zwischen intakten Zuständen oder eine Beschädigung des Sensors betreffen.

Die Feststellung, dass aktuelle Wertepaare für die Kapazitäten außerhalb eines Toleranzbereiches einer Funktion $c_r(c_p)$ bzw. $c_r(c_p,T)$ außerhalb eines Toleranzbereichs liegen, lässt sich mit einer hinreichenden Sicherheit vergleichsweise einfach treffen.

Wenn dagegen anhand von Wertepaaren der Kapazitäten eine Unterscheidung zwischen verschiedenen definierten Zuständen des Drucksensors zu treffen ist, kann es einen sinnvoll sein, den Zustand des Drucksensors mittels einer statistischen Analyse anhand mehrerer Wertepaare von Kapazitätswerten zu identifizieren. Hierzu können beispielsweise nach einer festgestellten Abweichung der Wertepaare von einer bisher gültigen Funktion $c_r(c_p)$ mehrere Wertepaare $c_r$, $c_p$ über einen hinreichend großen Wertebereich von $c_p$ erfasst werden, um dann anhand einer statistischen Analyse, beispielsweise einem Regressionsverfahren festzustellen, welcher Funktion die Wertepaare entsprechen. Falls keine Zuordnung zu einer einem intakten Zustand des Drucksensors entsprechenden Funktion möglich ist, wird ein Fehler festgestellt.

**Patentansprüche**

1. Verfahren zum Betreiben eines Drucksensors (1), wobei der Drucksensor (1) eine Messmembran (2), mindestens einen Gegenkörper (3) und einen kapazitiven Wandler mit mindestens einer ersten druckabhängigen Kapazität und einer zweiten druckabhängigen Kapazität aufweist,
wobei die Messmembran (2) ein Volumen druckdicht in ein erstes Teilvolumen und zweites Teilvolumen teilt, wobei das zweite Teilvolumen in einer Messkammer (5) zwischen der Messmembran (2) und dem Gegenkörper (3) eingeschlossen ist,
wobei eine Auslenkung der Messmembran (2) von einer Druckmessgröße p abhängt, welche eine Differenz zwischen einem ersten Druck $p_1$ in dem ersten Teilvolumen und einem zweiten Druck $p_2$ in dem zweiten Teilvolumen in der Messkammer (5) ist,
wobei die erste Kapazität und die zweite Kapazität jeweils zwischen einer Elektrode (7) an der Messmembran (2) und einer Gegenelektrode (8, 9) mit einer im wesentlichen druckunabhängigen Position gemessen werden,
wobei ein jeweils aktueller Wert der Druckmessgröße p in Abhängigkeit von der ersten Kapazität und von der zweiten Kapazität ermittelt wird,
wobei für einen intakten Drucksensor (1) im thermischen Gleichgewicht die zweite Kapazität als eine vorgegebene Funktion der ersten Kapazität und ggf. der Temperatur darstellbar ist,
wobei das Verfahren die folgenden Schritte aufweist:

Erfassen von Wertepaaren der ersten Kapazität und der zweiten Kapazität,
Prüfen, ob die erfassten Wertepaare der ersten Kapazität und der zweiten Kapazität innerhalb eines vorgegeben Toleranzbereichs tatsächlich dem Zusammenhang der vorgegebenen Funktion entsprechen,
Feststellen einer Veränderung und/oder Beschädigung des Sensors (1), wenn dies für einen Zeitraum, der länger andauert als ein Zeitgrenzwert, nicht der Fall ist,

**dadurch gekennzeichnet, dass**
der Zeitgrenzwert eine Funktion der Abweichung der Werte der ersten Kapazität und der zweiten Kapazität von dem Zusammenhang der Funktion ist.

**2.** Verfahren nach Anspruch 1, wobei die Zeitkonstante eine monoton fallende Funktion der Abweichung ist.

**3.** Verfahren nach einem der vorhergehenden Ansprüche, wobei ein intakter Drucksensor (1) einen ersten intakten Betriebszustand und mindestens einen zweiten intakten Betriebszustand aufweist,
wobei für einen intakten Drucksensor (1) im ersten Betriebszustand im thermischen Gleichgewicht die zweiten Kapazität als eine erste vorgegebene Funktion der ersten Kapazität und ggf. der Temperatur darstellbar ist,
wobei für einen intakten Drucksensor (1) im zweiten Betriebszustand im thermischen Gleichgewicht die zweiten Kapazität als eine zweite vorgegebene Funktion der ersten Kapazität und ggf. der Temperatur darstellbar ist,
wobei das Verfahren umfasst:

Prüfen, ob erfasste Werte der ersten Kapazität und der zweiten Kapazität innerhalb eines vorgegeben Toleranzbereichs tatsächlich dem Zusammenhang einer der vorgegebenen Funktionen entsprechen, und
Falls dies der Fall ist, Ermitteln der Druckmessgröße anhand einer Übertragungsfunktion, welche dem Betriebszustand zugeordnet ist, dem jene vorgegebene Funktion entspricht, deren Zusammenhang die erfassten Werte der ersten und der zweiten Kapazität genügen, und Feststellen einer Beschädigung des Sensors, falls dies für einen Zeitraum, der länger andauert als ein Zeitgrenzwert, nicht der Fall ist.

**4.** Verfahren nach Anspruch 3, wobei der Drucksensor (1) irreversibel von dem ersten intakten Betriebszustand in den zweiten intakten Betriebszustand übergeht.

**5.** Verfahren nach Anspruch 4, wobei das Verfahren die Schritte umfasst:

Überprüfen, ob sich der Sensor im ersten Betriebszustand befindet, und falls dies nicht der Fall ist;
Überprüfen ob sich der Sensor im zweiten Betriebszustand befindet;
und falls dies für einen Zeitraum, der länger andauert als ein Zeitgrenzwert, nicht der Fall ist, Feststellen einer Beschädigung des Drucksensors (1).

**6.** Verfahren nach einem der vorhergehenden Ansprüche, wobei der kapazitive Wandler einen Differentialkondensator umfasst, mit mindestens einem ersten Kondensator, dessen erste Kapazität eine erste Übertragungsfunktion aufweist, und einem zweiten Kondensator, dessen zweite Kapazität eine zweite Übertragungsfunktion aufweist, wobei die Übertragungsfunktionen sich in ihren Druckabhängigkeiten unterscheiden.

**7.** Verfahren nach Anspruch 6, wobei die beiden Kapazitäten gleich sind, wenn die Druckmessgröße den Wert Null aufweist.

**8.** Verfahren nach Anspruch 6 oder 7, wobei der Differentialkondensator eine kreisflächenförmige Messelektrode (8) und eine insbesondere kapazitätsgleiche kreisringförmige Referenzelektrode (9) aufweist, welche die Messelektrode (8) umgibt, wobei die Messelektrode (8) und die Referenzelektrode (9) insbesondere an einer der Messmembran (2) zugewandten Oberfläche eines Gegenkörpers angeordnet sind, wobei die Messmembran (2) eine kreisscheibenförmige Membranelektrode (9) aufweist, die sich vorzugsweise mindestens bis zum Außenrand der kreisringförmigen Referenzelektrode (9) erstreckt.

**9.** Verfahren nach Anspruch 8, wobei für die Druckmessgröße p gilt:

$$p = p((C_p - C_r) / C_r),$$

wobei $C_p$ und $C_r$ die Kapazitäten zwischen der Messelektrode (8) und der Membranelektrode (7) bzw. der Referenzelektrode (9) und der Membranelektrode (7) bezeichnen.

**10.** Verfahren nach einem der vorhergehenden Ansprüche, wobei der Drucksensor (1) eine keramische, kreisscheibenförmige Messmembran (2) und einen keramischen kreisplattenförmigen Gegenkörper (3) aufweist, wobei die Messmembran (2) entlang einer umlaufenden Fügestelle (4) unter der Bildung der Messkammer (5) druckdicht mit dem Gegenkörper (3) verbunden ist.

**11.** Verfahren nach einem der vorhergehenden Ansprüche, wobei der Drucksensor (1) in einem metallischen Gehäuse angeordnet ist, wobei der Drucksensor mit der Messmembran eine Gehäuseöffnung verschließt, durch welche die Messmembran mit einem Mediendruck beaufschlagbar ist, wobei das Gehäuse eine ringförmige Dichtfläche aufweist, welche die Gehäuseöffnung umgibt, wobei zwischen der Messmembran und der Dichtfläche ein Dichtring eingespannt ist, und wobei der Drucksensor auf der der Messmembran abgewandten Rückseite des Gegenkörpers mit einer Einspannvorrichtung abgestützt ist, um dem Drucksensor gegen den Dichtring gespannt zu halten.

12. Verfahren nach Anspruch 11, wobei der Dichtring ein Elastomer aufweist, wobei der Dichtring seine elastischen Eigenschaften irreversibel verändert, wenn er einer Temperatur ausgesetzt wird, die einen materialabhängigen Grenzwert überschreitet, wodurch sich auf die Messmembran und den Gegenkörper wirkende Einspannkräfte verändern, wodurch der Zusammenhang zwischen den Kapazitäten verändert wird,

wobei anhand von Wertepaaren $c_p$, $c_r$, ermittelt wird, welche Funktion $c_r(c_p)$ zur Beschreibung des aktuellen Zusammenhangs zwischen den Kapazitäten geeignet ist.

13. Verfahren nach Anspruch 12, wobei anhand der ermittelten geeigneten Funktion $c_r(c_p)$ eine Funktion $p(c_p, c_r, T)$ zur Ermittlung der Druckmessgröße gewählt wird.

**Claims**

1. Procedure for the operation of a pressure sensor (1), wherein the pressure sensor (1) has a process isolating diaphragm (2), at least one counter body (3) and a capacitive converter with at least a first pressure-dependent capacitance and a second pressure-dependent capacitance,

wherein the process isolating diaphragm (2) divides a volume in a pressure-tight manner into a first partial volume and a second partial volume, wherein the second partial volume is enclosed in a measuring chamber (5) between the process isolating diaphragm (2) and the counter body (3),

wherein a deflection of the process isolating diaphragm (2) depends on a pressure measured variable p, which constitutes a difference between the first pressure $p_1$ in the first partial volume and a second pressure $p_2$ in the second partial volume in the measuring chamber (5),

wherein the first capacitance and the second capacitance are measured in each case between an electrode (7) on the process isolating diaphragm (2) and a counter electrode (8, 9) with a position that is essentially independent of the pressure,

wherein a current value of the pressure measured variable p is determined depending on the first capacitance and the second capacitance,

wherein, for an intact pressure sensor (1) in thermal equilibrium, the second capacitance can be represented as a predefined function of the first capacitance and, where applicable, of the temperature,

wherein said procedure comprises the following steps:

Recording of value pairs of the first capacitance and the second capacitance,

Checking whether the recorded value pairs of the first capacitance and the second capacitance actually correspond to the correlation of the predefined function within a predefined tolerance range,

Determination of a change in and/or damage to a sensor (1) if this is not the case for a period that lasts longer than a time limit value,

**characterized in that**

the time limit value is a function of the deviation of the values of the first capacitance and second capacitance from the correlation of the function.

2. Procedure as claimed in Claim 1, wherein the time constant is a monotonic decreasing function of the deviation.

3. Procedure as claimed in one of the previous claims, wherein an intact pressure sensor (1) has a first intact operating state and at least a second intact operating state,

wherein, for an intact pressure sensor (1) in the first operating state in thermal equilibrium, the second capacitance can be represented as a first predefined function of the first capacitance and, where applicable, of the temperature,

wherein, for an intact pressure sensor (1) in the second operating state in thermal equilibrium, the second capacitance can be represented as a second predefined function of the first capacitance and, where applicable, of the temperature,

wherein the procedure comprises:

Checking whether recorded values of the first capacitance and the second capacitance actually correspond to the correlation of one of the predefined functions within a predefined tolerance range, and

If this is not the case, determining the pressure measured variable using a transfer function which is assigned to the operating state that corresponds to the predefined function where the correlation satisfies the recorded values for the first and second capacitance, and determining of damage to the sensor if this is not the case for a period that is longer than a time limit value.

4. Procedure as claimed in Claim 3, wherein the pressure sensor (1) transitions in an irreversible manner from the first intact operating state to the second intact operating state.

5. Procedure as claimed in Claim 4, wherein the procedure comprises the following steps:

Checking whether the sensor is in the first operating state, and if this is not the case;

Checking whether the sensor is in the second operating state;
and if this is not the case for a period that lasts longer than a time limit value,
Determination of damage to the pressure sensor (1).

6. Procedure as claimed in one of the previous claims wherein the capacitive converter comprises a differential capacitor with at least a first capacitor whose first capacitance has a first transfer function, and a second capacitor whose second capacitance has a second transfer function, wherein the transfer functions differ with regard to their pressure dependence.

7. Procedure as claimed in Claim 6, wherein the two capacitances are identical if the pressure measured variable has the value zero.

8. Procedure as claimed in Claim 6 or 7, wherein the differential capacitor has a measuring electrode (8) with a circular surface and a circular ring-shaped reference electrode (9), particularly of the same capacitance, that surrounds the measuring electrode (8), wherein the measuring electrode (8) and the reference electrode (9) are arranged, in particular, on a surface of a counter body that faces towards the process isolating diaphragm (2), wherein the process isolating diaphragm (2) has a disk-shaped membrane electrode (7), which preferably extends at least as far as the outer edge of the circular ring-shaped reference electrode (9).

9. Procedure as claimed in Claim 8, wherein the following formula applies for the pressure measured variable p :

$$p = p((C_p - C_r) / C_r),$$

where $C_p$ and $C_r$ refer to the capacitances between the measuring electrode (8) and the membrane electrode (7), and between the reference electrode (9) and the membrane electrode (7).

10. Procedure as claimed in one of the previous claims, wherein the pressure sensor (1) has a ceramic, circular disk-shaped measuring membrane (2), and a ceramic counter body (3) in the form of a circular plate, wherein the measuring membrane (2) is connected in a pressure-tight manner with the counter-body (3) along a circumferential joint (4), forming the measuring chamber (5).

11. Procedure as claimed in one of the previous claims, wherein the pressure sensor (1) is arranged in a metal housing, wherein the pressure sensor, with the process isolating diaphragm, seals a housing opening through which the process isolating diaphragm can be subjected to a medium pressure, wherein the housing has a ring-shaped sealing surface that surrounds the housing opening, wherein a sealing ring is clamped between the process isolating diaphragm and the sealing surface, and wherein the pressure sensor is supported by a clamping unit on the rear of the counter body facing away from the process isolating diaphragm in order to hold the pressure sensor tensioned against the sealing ring.

12. Procedure as claimed in Claim 11, wherein the sealing ring has an elastomer, wherein the sealing ring irreversibly changes its elastic properties when it is exposed to a temperature that exceeds a material-dependent limit value as result of which clamping forces acting on the measuring membrane and the counter body change, as a result of which the interrelation between the capacitances is changed, wherein value pairs $c_p$, $c_r$, are used to determine which function $c_r(c_p)$ is appropriate for describing the current correlation between the capacitances.

13. Procedure as claimed in Claim 12, wherein a function $p(c_p, c_r, T)$ for determining the pressure measured variable is selected on the basis of the appropriate function $c_r(c_p)$ which has been determined.

## Revendications

1. Procédé destiné à l'exploitation d'un capteur de pression (1),
pour lequel le capteur de pression (1) comporte une membrane de mesure (2), au moins un contre-corps (3) et un transducteur capacitif avec au moins une première capacité dépendant de la pression et une deuxième capacité dépendant de la pression,
pour lequel la membrane de mesure (2) divise de façon étanche à la pression un volume en un premier volume partiel et en un deuxième volume partiel, le deuxième volume partiel étant inclus dans une chambre de mesure (5) entre la membrane de mesure (2) et le contre-corps (3),
pour lequel une déviation de la membrane de mesure (2) dépend d'une grandeur de mesure de pression p, qui est une différence entre une première pression $p_1$ dans le premier volume partiel et une deuxième pression $p_2$ dans le deuxième volume partiel au sein de la chambre de mesure (5),
pour lequel la première capacité et la deuxième capacité sont mesurées respectivement entre une électrode (7) sur la membrane de mesure (2) et une contre-électrode (8, 9) avec une position pour l'essentiel indépendante de la pression,
pour lequel une valeur actuelle de la grandeur de mesure de pression p est déterminée respectivement en fonction de la première capacité et de la deuxième capacité,

pour lequel, pour un capteur de pression (1) intact en équilibre thermique, la deuxième capacité peut être représentée sous la forme d'une fonction prédéfinie de la première capacité et, le cas échéant, de la température,

lequel procédé comprend les étapes suivantes :

Saisie de couples de valeurs de la première capacité et de la deuxième capacité,

Contrôle si les couples de valeurs saisies de la première capacité et de la deuxième capacité correspondent effectivement à la relation de la fonction prédéfinie au sein d'une zone de tolérance prédéfinie,

Détermination d'une modification et/ou d'un endommagement du capteur (1), si ce n'est pas le cas pendant une période, qui est supérieure à une valeur limite de temps,

**caractérisé en ce que**

la valeur limite de temps est une fonction de l'écart des valeurs de la première capacité et de la deuxième capacité par rapport à la relation de la fonction.

2. Procédé selon la revendication 1, pour lequel la constante de temps est une fonction monotone décroissante de l'écart.

3. Procédé selon l'une des revendications précédentes, pour lequel un capteur de pression (1) intact présente un premier état de fonctionnement intact et au moins un deuxième état de fonctionnement intact,

pour lequel peut être représentée, pour un capteur de pression (1) intact dans le premier état de fonctionnement en équilibre thermique, la deuxième capacité en tant que première fonction prédéfinie de la première capacité et, le cas échéant, de la température,

pour lequel peut être représentée, pour un capteur de pression (1) intact dans le deuxième état de fonctionnement en équilibre thermique, la deuxième capacité en tant que deuxième fonction prédéfinie de la première capacité et, le cas échéant, de la température,

le procédé comprenant les étapes suivantes :

Contrôle si les valeurs saisies de la première capacité et de la deuxième capacité correspondent effectivement à la relation des fonctions prédéfinies au sein d'une zone de tolérance prédéfinie, et

Si c'est le cas, détermination de la grandeur de mesure de pression à l'aide d'une fonction de transfert, laquelle est affectée à l'état de fonctionnement, qui correspond à la fonction prédéfinie dont la relation satisfait aux valeurs saisies de la première et de la deuxième capacité, et

Détermination d'un endommagement du capteur, si ce n'est pas le cas pendant une période, qui est supérieure à une valeur limite de temps.

4. Procédé selon la revendication 3, pour lequel le capteur de pression (1) passe de façon irréversible du premier état de fonctionnement intact au deuxième état de fonctionnement intact.

5. Procédé selon la revendication 4, lequel procédé comprend les étapes suivantes :

Contrôle si le capteur est dans un premier état de fonctionnement, et si ce n'est pas le cas ;

Contrôle si le capteur est dans un deuxième état de fonctionnement ;

et si ce n'est pas le cas pendant une période, qui est supérieure à une valeur limite de temps,

Détermination d'un endommagement du capteur de pression (1).

6. Procédé selon l'une des revendications précédentes, pour lequel le transducteur capacitif comprend un condensateur différentiel, avec au moins un premier condensateur, dont la première capacité présente une première fonction de transfert, et un deuxième condensateur, dont la deuxième capacité présente une deuxième fonction de transfert, les fonctions de transfert se distinguant par leurs dépendances à la pression.

7. Procédé selon la revendication 6, pour lequel les deux capacités sont identiques lorsque la grandeur de mesure de pression présente la valeur zéro.

8. Procédé selon la revendication 6 ou 7, pour lequel le condensateur différentiel comporte une électrode de mesure (8) présentant une surface circulaire et une électrode de référence (9) présentant un anneau circulaire, notamment de capacité identique, cette dernière entourant l'électrode de mesure (8), l'électrode de mesure (8) et l'électrode de référence (9) étant disposées notamment sur une surface d'un contre-corps faisant face à la membrane de mesure (2), la membrane de mesure (2) comportant une électrode de membrane (7) en forme de disque circulaire, laquelle électrode s'étend de préférence au moins jusqu'au bord extérieur de l'électrode de référence (9) en forme d'anneau circulaire.

9. Procédé selon la revendication 8, pour lequel la formule suivante s'applique pour la grandeur de mesure de pression p :

$$p = p((C_p - C_r) / C_r),$$

où Cp et $C_r$ désignent respectivement les capacités entre l'électrode de mesure (8) et l'électrode de membrane (7), et entre l'électrode de référence (9) et l'électrode de membrane (7).

10. Procédé selon l'une des revendications précédentes, pour lequel le capteur de pression (1) comporte une membrane de mesure (2) en céramique, en forme de disque circulaire, et un contre-corps (3) en céramique, en forme de plaque circulaire, la membrane de mesure (2) étant reliée de façon étanche à la pression avec le contre-corps (3) le long d'un point de jonction (4) périphérique, formant ainsi la chambre de mesure (5).

11. Procédé selon l'une des revendications précédentes, pour lequel le capteur de pression (1) est disposé dans un boîtier métallique, l'ensemble capteur de pression et membrane de mesure obturant une ouverture du boîtier, à travers laquelle la membrane de mesure peut être soumise à une pression du fluide, le boîtier présentant une surface d'étanchéité annulaire, laquelle entoure l'ouverture du boîtier, une bague d'étanchéité étant serrée entre la membrane de mesure et la surface d'étanchéité, et le capteur de pression étant soutenu, sur la face arrière du contre-corps située à l'opposé de la membrane de mesure, à l'aide d'un dispositif de serrage afin de maintenir le serrage du capteur de pression contre la bague d'étanchéité.

12. Procédé selon la revendication 11, pour lequel la bague d'étanchéité est constituée d'un élastomère, la bague d'étanchéité modifiant de façon irréversible ses propriétés élastiques lorsqu'elle est exposée à une température, qui dépasse un seuil dépendant du matériau, entraînant la modification des forces de serrage agissant sur la membrane de mesure et le contre-corps, et entraînant la modification de la relation entre les capacités,
pour lequel il est déterminé, sur la base de couples de valeurs $c_p$, $c_r$, quelle fonction $c_r(c_p)$ est appropriée pour la description de la relation actuelle entre les capacités.

13. Procédé selon la revendication 12, pour lequel une fonction $p(c_p, c_r, T)$ est choisie sur la base de la fonction $c_r(c_p)$ appropriée déterminée, en vue de la détermination de la grandeur de mesure de pression.

**Fig. 1**

**Fig. 2**

**Fig. 3**

**Fig. 4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6029524 A
- US 2009301211 A1
- EP 2189774 A1
- EP 1518097 A